# EUROPEAN PATENT SPECIFICATION

(11) **EP 2 089 729 B1**
(45) Date of publication and mention of the grant of the patent: **02.01.2019**
(21) Application number: 06821773.6
(22) Date of filing: 09.11.2006
(51) Int. Cl.: G01R 31/34, G01R 31/12

(54) **METHOD FOR DETECTING PARTIAL DISCHARGES IN AN ELECTRIC MACHINE**
VERFAHREN ZUR ERKENNUNG VON TEILENTLADUNGEN IN EINER ELEKTRISCHEN MASCHINE
PROCÉDÉ DE DÉTECTION DE DÉCHARGES PARTIELLES DANS UNE MACHINE ÉLECTRIQUE

(43) Date of publication of application: 19.08.2009
(73) Proprietor: ANSALDO ENERGIA S.P.A., 16152 Genova (IT)
(72) Inventor: BENELLI, Carlo, 19020 Zignago (IT); CRESTA, Gabriele, 16156 Genova (IT); OLDRATI, Alessandro, 16129 Genova (IT)
(74) Representative: Bergadano, Mirko
(86) International application number: PCT/IT2006/000784
(87) International publication number: WO 2008/056385

(56) References cited:
- EP-A2- 1 645 887
- WO-A1-00/05536
- JP-A- 2 007 679
- JP-A- 2006 005 912
- US-A- 5 886 344
- US-A- 5 886 783
- KIMURA K ET AL: "Fluctuation of partial discharge inception voltage and discharge location of twisted pair sample under repetitive impulse voltage" ELECTRICAL INSULATING MATERIALS, 2005. (ISEIM 2005). PROCEEDINGS OF 2005 INTERNATIONAL SYMPOSIUM ON KITAKYUSHU, JAPAN 5-9 JUNE 2005, PISCATAWAY, NJ, USA,IEEE, US, 5 June 2005 (2005-06-05), pages 176-179Vol1, XP010827684 ISBN: 4-88686-063-X
- BAMJI S S ET AL: "Luminescence in polymeric insulation and its implication on insulation aging" ELECTRICAL INSULATING MATERIALS, 2001. (ISEIM 2001). PROCEEDINGS OF 2001 INTERNATIONAL SYMPOSIUM ON NOV. 19-22, 2001, PISCATAWAY, NJ, USA,IEEE, 19 November 2001 (2001-11-19), pages 453-458, XP010569948 ISBN: 4-88686-053-2
- BANJI, SOLI S.: "Electroluminescence - a technique to detect the initiation of degradation in polymeric insulation" IEEE, vol. 15, no. 3, June 1999 (1999-06), pages 9-14, XP011084569 Canada

## Description

### TECHNICAL FIELD

The present invention relates to a method for detecting partial discharges in an electric machine and a detecting device of partial discharges. Specifically, the present invention relates to a method for detecting partial discharges and to a partial discharge detecting device in electric machine windings.

### BACKGROUND ART

Electric machines, mainly alternators, comprise a plurality of electric windings, each of which is essentially formed by electrically conducting elements, which extend along a path defined within the electric machine and are coated with insulating material.

The occurrence of partial discharges on an electric machine winding is a symptom of decay of the insulating material of the winding itself, which may cause, if not corrected, a failure of the insulation with considerable consequences for the correct operation of the electric machine.

Partial discharges are electric discharges along conductive paths which may occur either through the insulating material or, externally, on its surface and which are always associated with a photonic emission of variable intensity. Such discharges may be distinguished between superficial partial discharges (corona effect), winding insulator, and internal partial discharges, when they take place within the insulator.

Superficial partial discharges are due to imperfections (dirt, mechanical damages, incorrect distances, etc.) which cause electric field build-ups on the surface of the insulator, while internal partial discharges originate from the presence of cavities (vacuoles) within the insulator. Such cavities may be caused by constructive imperfections, but are generally formed with the increase of running time due to the stress to which the insulation is subjected.

The exact localisation of partial discharges is crucial in design steps, in new material assessment and in the diagnostics of electric machines in use.

Conventional optical methods and devices for detecting partial discharges use one-dimensional type sensors (such as Vidicon tubes, photomultipliers, photodiodes, etc.) which allow to quantify the level of photonic emission associated with the partial discharge, but not to provide a precise and punctual localisation of the phenomenon. Furthermore, such sensors have low quantic efficiency and a relatively narrow wavelength operating band and, therefore, are not very sensitive to the light photonic emissions associated with partial discharges. In document KIMURA K ET AL: "Fluctuation of partial discharge inception voltage and discharge location of twisted pair sample under repetitive impulse voltage" ELECTRICAL INSULATING MATERIALS, 2005. (ISEIM 2005) Proceedings Of 2005 International Symposium On Kitakyushu, Japan 5-9 June 2005, Piscataway, NJ, USA, IEEE, US, 5 June 2005 (2005-06-05), pages 176-179 Vol.1, 4-88686-063-X is described a device for detecting partial discharges that uses a CCD sensor for detecting photonic emissions. Similar kind of device are discloses also in US5886783, JP2006005912, JP2007679, BAMJI S ET AL: "Luminescence in polymeric insulation and its implication on insulation aging" ELECTRICAL INSULATING MATERIALS, 2001 Proceedings Of 2001 International Symposium On Nov. 19-22, 2001, Piscataway, NJ, USA, IEEE, 19 November 2001 (2001-11-19), pages 453-458, ISBN: 4-88686-053-2 and BANJI, SOLI S.: "Electroluminescence - a technique to detect the initiation of degradation in polymeric insulation" IEEE, vol. 15, no. 3, June 1999 (1999-06), pages 9-14, Canada, US-5886344 A, EP-1670108 A1 and WO-00/05536 A1.

It is an object of the present invention to provide a method for the optical detection of partial discharges which is free from the drawbacks illustrated hereto and, particularly, which allow to localise the partial discharges in a precise and punctual manner.

In accordance with such objects, the present invention relates to a method for detecting partial discharges as claimed in claim 1.

Further features and advantages of the present invention will be apparent from the following description of a non-limitative example of an embodiment, with reference to the figures in the accompanying drawings, in which:
- figure 1 is a block diagram of the partial discharge detecting device according to the present invention;
- figure 2 is a detail of the partial discharge detecting device according to the present invention;
- figure 3 is a simplified flow diagram related to the partial discharge detection and localisation method according to the present invention;
- figure 4 is a more detailed flow diagram of a first step of the partial discharge detection and localisation method in figure 3; and
- figure 5 is a more detailed flow diagram of a second step of the partial discharge detection and localisation method in figure 4.

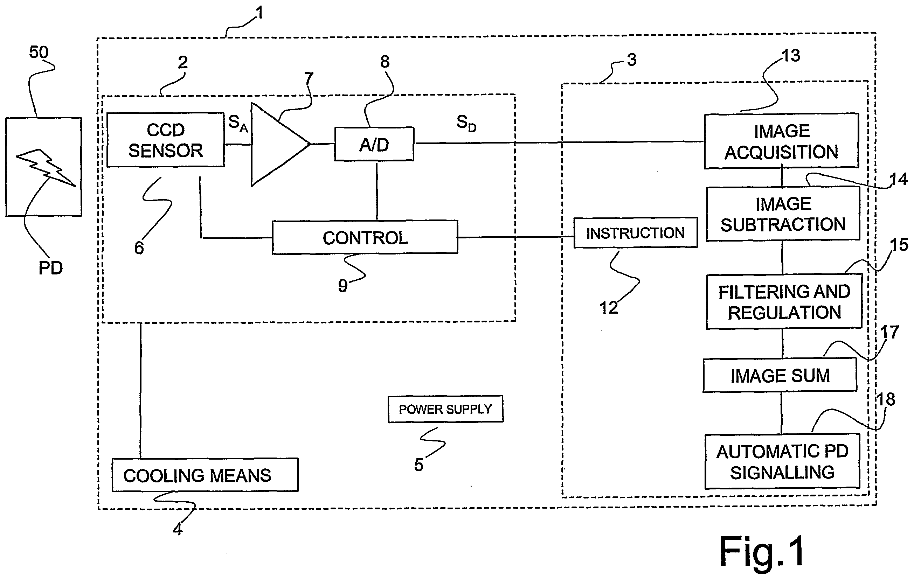

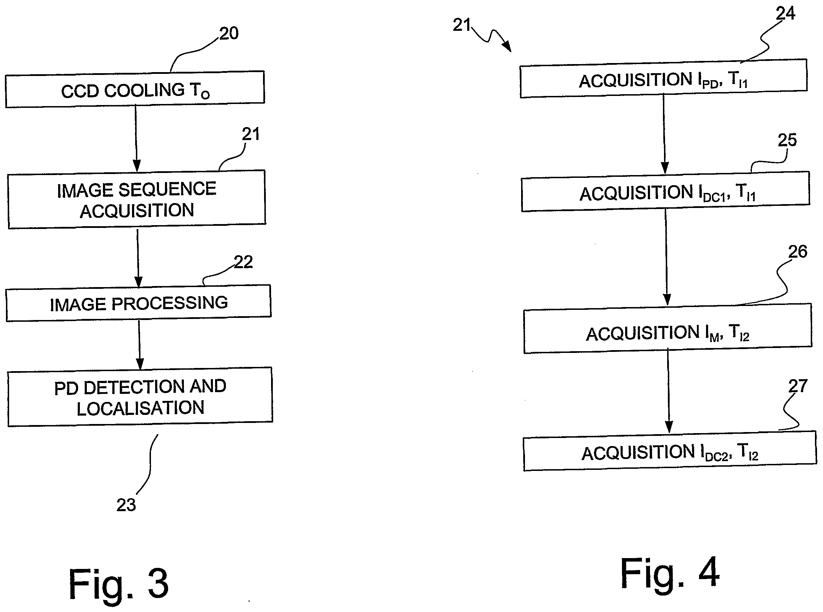

Figure 1 shows a block diagram of a partial discharge detecting device 1 for according to the present localisation method in figure 4.

### BEST MODE FOR CARRYING OUT THE INVENTION

Figure 1 shows a block diagram of a partial discharge detecting device 1 for according to the present invention. Partial discharges PD may for example occur on windings (not shown in the attached figures) of an electric machine 50 (during tests with machine either stopped or running). A photonic emission, generally of low intensity, is associated with each partial discharge PD.

Device 1 comprises an image detector 2, a processing unit 3, cooling means 4 and a power unit 5.

Image detector 2 comprises a CCD (Charge Coupled Device) sensor 6, an amplification module 7, coupled to the CCD sensor 6, an A/D converter 8 and a control module 9.

CCD sensor 6, not shown in detail, comprises a plurality of charge integration sites, generally formed by MOS capacitors and arranged so as to form a flat array (the charge integration sites are also called "pixels"). When CCD sensor 6 is placed, in known manner, in a charge integration configuration, the pixels may accumulate corresponding quantities of charge. The charge collected by each pixel is essentially proportional to the quantity of photons inciding locally on CCD sensor 6 and also comprises a spurious contribution due to the spontaneous generation of hole-electron pairs by thermal action (the so-called "dark current"). The time interval in which CCD sensor 6 is placed in charge integration configuration is called integration time T_{I}.

After integration, the pixels are read in sequence, generating an analogue signal S_{A}, which allows to reconstruct the image "seen" by the pixel array. CCD sensor 6 is preferably a high-sensitivity astronomy-derived sensor provided with a high quantic efficiency in a broad wavelength spectrum.

Amplification module 7 is coupled to CCD sensor 6 to receive and amplify analogue signal S_{A}. A/D converter 8 is cascade connected to amplification module 7 and is configured to convert amplified analogue signal S_{A} into a digital signal S_{D}. Control module 9 is configured to control CCD sensor 6 and A/D converter 8 during the charge integration, pixel reading and analogue signal S_{A} conversion steps.

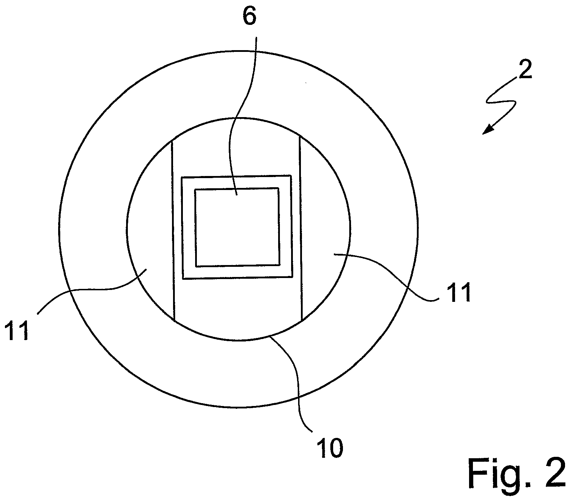

With reference to figure 2, image detector 2 also comprises a lens 10 and a shutter 11, adapted to be selectively opened and closed to expose CCD sensor 6 to photonic radiation and to shield it respectively. Here and hereinafter, exposure time means the time during which shutter 11 remains open and CCD sensor 6 is exposed to incident photonic radiation.

With reference to figure 1, image detector 2 is coupled to cooling means 4, which are adapted to take and maintain CCD sensor 6 at an operative temperature Tₒ lower than the ambient temperature and preferably lower than -30°C, in order to reduce the characteristic thermal noise of CCD sensor 6 due to the spontaneous phenomenon of electron thermal agitation. Generally, cooling means 4 comprise a forced air- or water-cooled Peltier cell (not shown in the accompanying figures). The cooling of CCD sensor 6, by reducing the thermal noise, allows the acquisition of images with a relatively long integration time T_{I} with respect to the integration times typical of the commercially available CCD sensors and guarantees that during such integration time T_{I} most of the collected electrons are generated by photoelectric effect and not by thermal agitation. Specifically, the cooling allows sufficiently long integration times T_{I} to detect an extremely weak photonic emission, such as that associated with partial discharges PD (for example, one hour) .

Processing unit 3 is connected to image detector 2 through a USB (Universal Serial Bus) connection and is configured to provide instructions to image detector 2 and to identify the position of each partial discharge PD.

Specifically, processing unit 3 comprises an instruction module 12, which provides instructions to control module 9 of image detector 2, an image acquisition module 13, an image subtraction module 14, an image filtering and adjustment module 15, an image sum module 17 and an automatic signalling module 18 of partial discharges PD.

More in detail, instruction module 12 provides to control module 9 instructions on integration times T_{I}, on exposure times and, in general, on the parameters needed for a correct and adequate image acquisition.

Power unit 5 is adapted to provide electric power to image detector 2.

Figure 3 shows a flow chart related to an embodiment of a method for detecting and localising partial discharges PD according to the present invention.

By cooling means 4, CCD sensor 6 is initially cooled to a predetermined operative temperature Tₒ (block 20), which is maintained until CCD sensor 6 is working. Once operative temperature Tₒ is reached, image detector 2 is used to acquire a sequence of images of the electric machine under observation, in different lighting conditions and with different exposure features (block 21), as described in detail further below. The images thus obtained are then numerically processed by processing unit 3 (block 22), which detects and localises possible partial discharges PD (block 23).

With reference to figure 4, the above-described sequence of images (block 21 in figure 3) comprises four images.

A partial discharge image I_{PD} is acquired in absence of lighting and with machine 50 under voltage supply, to detect possible partial discharges PD (block 24). The acquisition occurs with CCD sensor 6 exposed, i.e. with shutter 11 open, and with a first sufficiently long integration time T_{I1} to allow the detection of photonic emissions associated with partial discharges PD and however such that it avoids saturation of the CCD sensor 6 pixels. The accumulation capacity of a pixel is, indeed, limited, and in case of saturation, the charge in excess migrates towards the adjacent pixels giving rise to a phenomenon called "blooming", which deteriorates the quality of the image.

A first dark current image I_{DC1} is acquired (block 25), in order to estimate the dark current contribution associated with the partial discharge image I_{PD} acquisition step, and, more in general, the noise contribution of the entire acquisition chain from CCD sensor 6 to A/D converter 8. CCD sensor 6, as previously set forth, has the property of spontaneously producing and accumulating electrons by thermal agitation both during exposure and when the surface of CCD sensor 6 is shielded from incident light, i.e. when shutter 11 is closed. In order to correctly assess the contribution of dark current, the first dark current image I_{DC1} is acquired with shutter closed 11 and with an integration time equal to first integration time T_{I1} used to acquire partial discharge image I_{PD}. Furthermore, first dark current image I_{DC1} is acquired in rapid sequence to partial discharge image I_{PD} and in conditions as similar as possible (i.e., with machine 50 power supplied and in the absence of lighting). The temperature and the electromagnetic fields indeed significantly influence the dark current intensity.

A machine image I_{M} (block 26) is acquired when electric machine 50 is not power supplied and therefore no partial discharges PD occur. Furthermore, machine image I_{M} is acquired with shutter 11 open and in the presence of an active light source, which is generally external to device 1 and is preferably controlled by processing unit 3. The acquisition of machine image I_{M} is performed with a second integration time T_{I2} such as to avoid the pixel saturation of CCD sensor 6.

A second dark current image I_{DC2} (block 27) is then acquired in the conditions in which machine image I_{M} was acquired, to estimate the dark current contribution associated with the acquisition step of machine image I_{M}. Electric machine 50 is not therefore power supplied. The acquisition of second dark current image I_{DC2} occurs however with CCD sensor 6 shielded, i.e. with shutter 11 closed, and with an integration time equal to second integration time T_{I2} used for the acquisition of machine image I_{M}. Second integration time T_{I2} is lower than the limit time at which pixel saturation of CCD sensor 6 occurs and, specifically, is lower than first integration time T_{I1}.

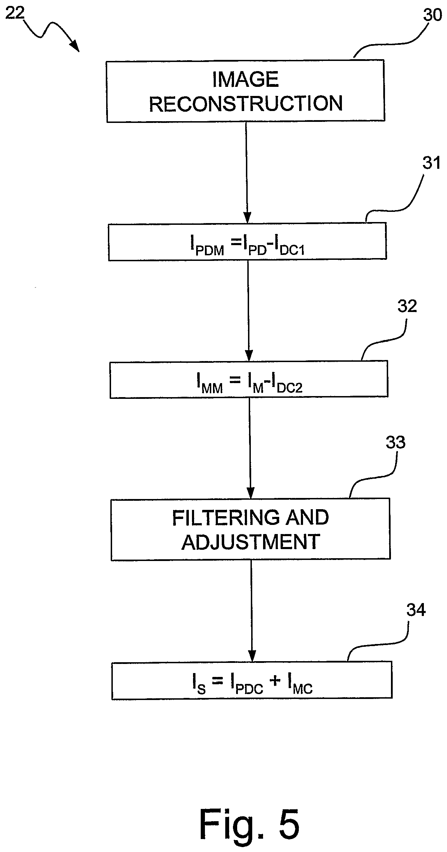

With reference to figure 5, the numeric processing of the acquired images (block 22 in figure 3) comprises the following steps.

Image acquisition module 13 receives digital signal S_{D} from image detector 2 and uses it to reconstruct partial discharge image I_{PD}, machine image I_{M} and first and second dark current images I_{DC1}, I_{DC2} (block 30) .

Then, image subtraction module 14 subtracts first dark current image I_{DC1} from partial discharge image I_{PD} (block 31) to obtain a modified partial discharge image I_{PDM}. This operation eliminates the noise caused by dark current from partial discharge image I_{PD}. In identical environmental and integration time duration T_{I} conditions, indeed, CCD sensor 6 essentially always accumulates the same charge caused by dark current, both when it is exposed to an external light source and when it is shielded.

Similarly (block 32), image subtraction module 14 subtracts second dark current image I_{DC2} from machine image I_{M} to obtain a modified machine image I_{MM}.

Of course, it is understood that the subtraction of second dark current image I_{DC2} from machine image I_{M} may be performed before the subtraction of first dark current image I_{DC1} from partial discharge image I_{PD}.

Modified machine image I_{MM} and modified partial discharge image I_{PDM} are then filtered and adjusted by filtering and adjustment module 15 (block 33). The filtering, specifically, contemplates the use of known digital filters, different according to the investigation needs (high-pass, low-pass, media, sharpening, gradient, Sobel, Kirsch, Prewitt, Gauss, Laplacian, etc.). The image adjustment, instead, contemplates the optimisation of some features of the images, such as brightness and contrast, in order to ease the interpretation of image details.

After filtering and adjustment, modified machine image I_{MM} and modified partial discharge image I_{PDM} are summed by image sum module 17 (block 35) to obtain a sum imagine I_{S}, in which partial discharges PD are visible and localisable. The sum of modified machine image I_{MM} and of modified partial discharge image I_{PDM} allows to establish an accurate correlation between machine geometry 50 and partial discharges PD detected by device 1.

The localisation of partial discharges PD detected and visible in sum image I_{S} is performed automatically by automatic partial discharge signalling module 18 (figure 3).

The invention has the following advantages.

First, the method for detecting and localising partial discharges PD according to the present invention provides a precise and punctual indication of the partial discharge PD phenomenon on the windings of an electric machine, with a modest energising of the winding (in the case of off-line measurements). Such a method is effective and besides is not open to subjective interpretations, unlike other methods still very used today (for example, visual detection in dark chamber).

Second, the method for detecting partial discharges PD according to the present invention may be advantageously used in combination with an electric partial discharge PD detection method, for example by means of the device disclosed in European Patent Application EP 1645887 filed by the same applicant. The results obtained with the electric method are advantageously integrable with the qualitative results of the method according to the present invention because they provide a quantitative assessment of the partial discharge PD phenomenon.

Third, the method for detecting partial discharges PD according to the present invention allows to perform a predictive diagnostics aimed at minimising the risk of failure of the electric machine insulation. The assessment activity of the conditions of the winding insulator in an electric machine by means of the device according to the present invention is simple and fast and may be performed during the normal routine maintenance interventions with evident advantages from the point of view of lifespan of the electric machine. Such possibility leads to a reduction of costs, for the system user, due to maintenance and to failed production caused by machine downtime.

Finally, the device and the method according to the present invention are very useful during the test and design steps of the new insulating materials in order to increase new product reliability.

## Claims

1. A method for detecting partial discharges (PD) in an electric machine (50), comprising the step of detecting photonic emissions associated with partial discharges (PD) using a CCD sensor (6); the method being **characterised in that** it comprises the steps of:
- acquiring, by using the CCD sensor, a partial discharge image (24, I_{PD}) of at least one portion of the electric machine (50) in absence of lighting, wherein the electric machine (50) is power supplied in order to detect possible partial discharges (PD);
- estimating a first dark current contribution (25, I_{DC1}) associated with the partial discharge image acquisition step (24, I_{PD});
- eliminating the first dark current contribution (25, I_{DC1}) from the partial discharge image (I_{PD});
- acquiring, by using the CCD sensor, a machine image (26, I_{M}) of the portion of the electric machine (50) in presence of lighting, wherein the electric machine (50) is not power supplied so no partial discharges (PD) occur;
- estimating a second dark current contribution (27, I_{DC2}) associated with the machine image acquisition step (26, I_{M});
- eliminating the second dark current contribution (27, I_{DC2}) from the machine image (I_{M});
- generating a sum image (I_{S}) from the partial discharge image (I_{PD}) and from the machine image (I_{M}) wherein partial discharges are visible and localisable.

2. A method according to claim 1, **characterised in that** it comprises the step of cooling (20) the CCD sensor (6) for reducing the intrinsic CCD sensor (6) thermal noise .

3. A method according to claim 2, **characterised in that** the step of cooling (20) comprises taking the CCD sensor (6) to an operative temperature (T₀) lower than an ambient temperature.

4. A method according to claim 3, **characterised in that** the operative temperature (T₀) is lower than -30°C.

5. A method according to any foregoing Claims, **characterised in that** the step of acquiring a partial discharge image (24, I_{PD}) comprises:
placing the CCD sensor (6) in a charge integration configuration for a first integration time (T_{I1}); and
exposing the CCD sensor (6) during the first integration time (T_{I1}); and
the step of estimating a first dark current contribution (25, I_{DC1}) comprises:
shielding the CCD sensor (6) from photonic radiations; and placing the shielded CCD sensor (6) in a charge integration configuration for a time equal to the first integration time (T_{I1}).

6. A method according to Claim 5, **characterised in that** the step of acquiring the machine image (26, I_{M}) comprises:
placing the CCD sensor (6) in a charge integration configuration for a second integration time (T_{I2}); and exposing the CCD sensor (6) during the second integration time (T_{I2}); and
the step of estimating the second dark current contribution (I_{DC2}) comprises:
shielding the CCD sensor (6) from photonic radiations; and placing the shielded CCD sensor (6) in a charge integration configuration for a time equal to the second integration time (T_{I2}).

7. A method according to claim 6, **characterised in that** the first integration time (T_{I1}) is sufficiently long to allow the detection of photonic emissions associated with partial discharges (PD) and the second integration time (T_{I2}) is sufficient to create a visible image of the portion of the electric machine.

8. A method according to anyone of the foregoing Claims, **characterised in that**:
the step of eliminating the first dark current contribution (I_{DC1}) comprises subtracting the first dark current contribution (I_{DC1}) from the partial discharge image (I_{PD}), to generate a first modified image (31,I_{PDM});
the step of eliminating the second dark current contribution (I_{DC2}) comprises subtracting the second dark current contribution (I_{DC2}) from the machine image (I_{M}), to generate a second modified image (32,I_{MM}); and
the step of generating the sum image (34, I_{S}) comprises summing the first modified image (I_{PDM}) to the second modified image (I_{MM}).

9. A method according to claim 8, **characterised in that** the step of generating the sum image (I_{S}) comprises filtering and adjusting the first modified image (I_{PDM}) and the second modified image (I_{MM}).

10. A method according to anyone of foregoing Claims, **characterised in that** it comprises the step of localising the partial discharges (PD) by means of an automatic signalling module (18) from the sum image (I_{S}).

## Patentansprüche

1. Verfahren zur Detektion von Teilentladungen (PD) in einer elektrischen Maschine (50), wobei das Verfahren den Schritt umfasst, in dem mittels eines CCD-Sensors (6) mit Teilentladungen (PD) verbundene Photonenemissionen detektiert werden;
wobei das Verfahren durch folgende Schritte gekennzeichnet ist:
- Erfassen eines Teilentladungsbildes (24, I_{PD}) mindestens eines Bereichs der elektrischen Maschine (50) mittels des CCD-Sensors in Abwesenheit von Licht, wobei die elektrische Maschine (50) mit Strom versorgt wird, so dass mögliche Teilentladungen (PD) detektiert werden;
- Schätzen eines mit dem Schritt der Erfassung des Teilentladungsbildes (24, I_{PD}) verbundenen ersten Dunkelstrombeitrags (25, I_{DC1});
- Eliminieren des ersten Dunkelstrombeitrags (25, I_{DC1}) von dem Teilentladungsbild (I_{PD});
- Erfassen eines Maschinenbildes (26, I_{M}) des Bereichs der elektrischen Maschine (50) mittels des CCD-Sensors bei Vorhandensein von Licht, wobei die elektrische Maschine (50) nicht mit Strom versorgt wird, so dass keine Teilentladungen (PD) auftreten;
- Schätzen eines mit dem Schritt der Erfassung des Maschinenbildes (26, I_{M}) verbundenen zweiten Dunkelstrombeitrags (27, I_{DC2});
- Eliminieren des zweiten Dunkelstrombeitrags (27, I_{DC2}) von dem Maschinenbild (I_{M});
- Generieren eines Summenbildes (I_{S}) mittels des Teilentladungsbildes (I_{PD}) und des Maschinenbildes (I_{M}), wobei die Teilentladungen sichtbar und lokalisierbar sind.

2. Verfahren nach Anspruch 1, **dadurch gekennzeichnet, dass** das Verfahren das Kühlen (20) des CCD-Sensors (6) umfasst, um das dem CCD-Sensor (6) eigene Wärmerauschen zu reduzieren.

3. Verfahren nach Anspruch 2, **dadurch gekennzeichnet, dass** der Schritt des Kühlens (20) das Versetzen des CCD-Sensors (6) in eine Betriebstemperatur (T₀) umfasst, die unter einer Umgebungstemperatur liegt.

4. Verfahren nach Anspruch 3, **dadurch gekennzeichnet, dass** die Betriebstemperatur (T₀) unter -30°C liegt.

5. Verfahren nach einem der vorstehenden Ansprüche, **dadurch gekennzeichnet, dass** der Schritt des Erfassens eines Teilentladungsbildes (24, I_{PD}) Folgendes umfasst:
Versetzen des CDD-Sensors (6) in eine Ladungsintegrationsanordnung für eine erste Integrationszeit (T_{I1}); und
Belichten des CDD-Sensors (6) während der ersten Integrationszeit (T_{I1}); wobei
der Schritt des Schätzens eines ersten Dunkelstrombeitrags (25, I_{DC1}) Folgendes umfasst:
Abschirmen des CDD-Sensors (6) vor Photonenstrahlung; und
Versetzen des CDD-Sensors (6) in eine Ladungsintegrationsanordnung für einen Zeitraum, der gleich der ersten Integrationszeit (T_{I1}) ist.

6. Verfahren nach Anspruch 5, **dadurch gekennzeichnet, dass** der Schritt des Erfassens des Maschinenbildes (26, I_{M}) Folgendes umfasst:
Versetzen des CDD-Sensors (6) in eine Ladungsintegrationsanordnung für eine zweite Integrationszeit (T_{I2}); und
Belichten des CDD-Sensors (6) während der zweiten Integrationszeit (T_{I2}); wobei
der Schritt des Schätzens des zweiten Dunkelstrombeitrags (I_{DC2}) Folgendes umfasst:
Abschirmen des CDD-Sensors (6) vor Photonenstrahlung; und
Versetzen des CDD-Sensors (6) in eine Ladungsintegrationsanordnung für einen Zeitraum, der gleich der zweiten Integrationszeit (T_{I2}) ist.

7. Verfahren nach Anspruch 6, **dadurch gekennzeichnet, dass** die erste Integrationszeit (T_{I1}) ausreichend lang ist, um die Detektion der mit den Teilentladungen (PD) verbundenen Photonenemissionen zu ermöglichen, und die zweite Integrationszeit (T_{I2})ausreichend lang ist, um ein sichtbares Bild des Bereichs der elektrischen Maschine zu erzeugen.

8. Verfahren nach einem der vorstehenden Ansprüche, **dadurch gekennzeichnet, dass**:
der Schritt des Eliminierens des ersten Dunkelstrombeitrags (25, I_{DC1}) das Subtrahieren des ersten Dunkelstrombeitrags (25, I_{DC1}) von dem Teilentladungsbild (I_{PD}) umfasst, um ein erstes modifiziertes Bild (31, I_{PDM}) zu erzeugen;
der Schritt des Eliminierens des zweiten Dunkelstrombeitrags (I_{DC2}) das Subtrahieren des zweiten Dunkelstrombeitrags (I_{DC2}) von dem Maschinenbild (I_{M}) umfasst, um ein zweites modifiziertes Bild (32, I_{MM}) zu erzeugen; und
der Schritt des Generierens des Summenbildes (34, I_{S}) das Addieren des erstes modifizierten Bildes (I_{PDM}) und des zweiten modifizierten Bild (I_{MM}) umfasst.

9. Verfahren nach Anspruch 8, **dadurch gekennzeichnet, dass** der Schritt des Generierens des Summenbildes (I_{S}) das Filtern und Anpassen des erstes modifizierten Bildes (I_{PDM}) und des zweiten modifizierten Bild (I_{MM}) umfasst.

10. Verfahren nach einem der vorstehenden Ansprüche, **dadurch gekennzeichnet, dass** das Verfahren das Lokalisieren der Teilentladungen (PD) mittels eines automatischen Signalgebungsmoduls (18) anhand des Summenbildes (I_{S}) umfasst.

## Revendications

1. Procédé destiné à détecter des décharges partielles (PD) dans une machine électrique (50), comprenant l'étape consistant à détecter des émissions photoniques associées à des décharges partielles (PD) en utilisant un capteur à CCD (6) ;
le procédé étant **caractérisé en ce qu'**il comprend les étapes consistant à :
- acquérir, à l'aide du capteur à CCD, une image d'une décharge partielle (24, I_{PD}) d'une partie au moins de la machine électrique (50) en l'absence d'éclairage, dans lequel la machine électrique (50) est alimentée de façon à détecter de possibles décharges partielles (PD) ;
- estimer une première contribution d'un courant d'obscurité (25, I_{DC1}) associée à l'étape d'acquisition d'une image d'une décharge partielle (24, I_{PD}) ;
- éliminer la première contribution d'un courant d'obscurité (25, I_{DC1}) de l'image d'une décharge partielle (I_{PD});
- acquérir, à l'aide du capteur à CCD, une image machine (26, I_{M}) de la partie de la machine électrique (50) en présence d'éclairage, dans lequel la machine électrique (50) n'est pas alimentée, et donc aucune décharge partielle (PD) ne se produit ;
- estimer une seconde contribution d'un courant d'obscurité (27, I_{DC2}) associée à l'étape d'acquisition d'une image machine (26, I_{M});
- éliminer la seconde contribution d'un courant d'obscurité (27, I_{DC2}) de l'image machine (I_{M});
- générer une image somme (I_{S}) à partir de l'image d'une décharge partielle (I_{PD}), et de l'image machine (I_{M}), dans laquelle des décharges partielles sont visibles et peuvent être localisées.

2. Procédé selon la revendication 1, **caractérisé en ce qu'**il comprend l'étape consistant à refroidir (20) le capteur à CCD (6) de façon à réduire le bruit thermique intrinsèque du capteur à CCD (6).

3. Procédé selon la revendication 2, **caractérisé en ce que** l'étape de refroidissement (20) comprend une étape consistant à placer le capteur à CCD (6) à une température opérationnelle (To) inférieure à la température ambiante.

4. Procédé selon la revendication 3, **caractérisé en ce que** la température opérationnelle (To) est inférieure à - 30 °C.

5. Procédé selon l'une quelconque des revendications précédentes, **caractérisé en ce que** l'étape consistant à acquérir une image d'une décharge partielle (24, I_{PD}) comprend les étapes consistant à :
- placer le capteur à CCD (6) dans une configuration d'intégration de charges au cours d'une première durée d'intégration (T_{I1}) ; et
- exposer le capteur à CCD (6) au cours de la première durée d'intégration (T_{I1}) ; et
l'étape consistant à estimer une première contribution d'un courant d'obscurité (25, I_{DC1}) comprend les étapes consistant à :
- blinder le capteur à CCD (6) vis-à-vis de rayonnements photoniques ; et
- placer le capteur à CCD blindé (6) dans une configuration d'intégration de charges au cours d'une durée égale à la première durée d'intégration (T_{I1}).

6. Procédé selon la revendication 5, **caractérisé en ce que** l'étape consistant à acquérir l'image machine (26, I_{M}) comprend les étapes consistant à :
- placer le capteur à CCD (6) dans une configuration d'intégration de charges au cours d'une seconde durée d'intégration (T_{I2}) ; et
- exposer le capteur à CCD (6) au cours de la seconde durée d'intégration (T_{I2}) ; et
l'étape consistant à estimer la seconde contribution d'un courant d'obscurité (I_{DC2}) comprend les étapes consistant à :
- blinder le capteur à CCD (6) vis-à-vis de rayonnements photoniques ; et
- placer le capteur à CCD blindé (6) dans une configuration d'intégration de charges au cours d'une durée égale à la seconde durée d'intégration (T_{I2}).

7. Procédé selon la revendication 6, **caractérisé en ce que** la première durée d'intégration (T_{I1}) est suffisamment longue de façon à permettre la détection des émissions photoniques associées à des décharges partielles (PD), et la seconde durée d'intégration (T_{I2}) est suffisante de façon à créer une image visible de la partie de la machine électrique.

8. Procédé selon l'une quelconque des revendications précédentes, **caractérisé en ce que** :
l'étape consistant à éliminer la première contribution d'un courant d'obscurité (I_{DC1}) comprend une étape consistant à soustraire la première contribution d'un courant d'obscurité (I_{DC1}) de l'image de décharge partielle (I_{PD}), de façon à générer une première image modifiée (31, I_{PDM});
l'étape consistant à éliminer la seconde contribution d'un courant d'obscurité (I_{DC2}) comprend une étape consistant à soustraire la seconde contribution d'un courant d'obscurité (I_{DC2}) de l'image machine (I_{M}), de façon à générer une seconde image modifiée (32, I_{MM}); et
l'étape consistant à générer l'image somme (34, I_{S}) comprend une étape consistant à additionner la première image modifiée (I_{PDM}) et la seconde image modifiée (I_{MM}).

9. Procédé selon la revendication 8, **caractérisé en ce que** l'étape consistant à générer l'image somme (I_{S}) comprend les étapes consistant à filtrer et à régler la première image modifiée (I_{PDM}) et la seconde image modifiée (I_{MM}).

10. Procédé selon l'une quelconque des revendications précédentes, **caractérisé en ce qu'**il comprend consistant à localiser les décharges partielles (PD) à l'aide d'un module de signalisation automatique (18) à partir de l'image somme (I_{S}).
